# FASCICULE DE BREVET EUROPEEN

(11) **EP 3 698 066 B1**
(45) Date de publication et mention de la délivrance du brevet: **30.11.2022**
(21) Numéro de dépôt: 18803457.3
(22) Date de dépôt: 16.10.2018
(51) Int. Cl.: F16D 69/02, F16D 65/12, C23C 16/455, C23C 16/30, C23C 16/04, C04B 35/83, C23C 16/26, C23C 16/40, C23C 16/56

(54) **PROCEDE DE FABRICATION D'UNE PIECE DE FRICTION EN MATERIAU COMPOSITE**
VERFAHREN ZUR HERSTELLUNG EINES VERBUNDREIBBAUTEILS
PROCESS FOR MANUFACTURING A COMPOSITE FRICTION PART

(30) Priorité: 19.10.2017 FR 1759873
(43) Date de publication de la demande: 26.08.2020
(73) Titulaire: Safran Ceramics, 33185 Le Haillan (FR); Centre National de la Recherche Scientifique, 75016 Paris (FR)
(72) Inventeur: BOUILLON, Eric, 77550 Moissy-Cramayel (FR); DELEHOUZE, Arnaud, 77550 Moissy-Cramayel (FR); LORRIAUX, Amandine, 33000 Bordeaux (FR); MAILLE, Laurence, 33000 Bordeaux (FR)
(74) Mandataire: Cabinet Beau de Loménie
(86) Numéro de dépôt international: PCT/FR2018/052571
(87) Numéro de publication internationale: WO 2019/077260

(56) Documents cités:
- EP-A1- 2 253 604
- FR-A1- 2 869 609
- US-A1- 2008 282 970
- US-A1- 2012 329 286
- US-A1- 2016 233 085
- GASKELL ET AL: "Liquid injection MOCVD and ALD of ZrO"2 using Zr-cyclopentadienyl precursors", SURFACE AND COATINGS TECHNOLOGY, ELSEVIER BV, AMSTERDAM, NL, vol. 201, no. 22-23, 9 août 2007 (2007-08-09), pages 9095-9098, XP022191940, ISSN: 0257-8972, DOI: 10.1016/J.SURFCOAT.2007.04.098

## Description

L'invention concerne la fabrication de pièces de friction à base de matériau composite carbone/carbone (C/C), telles que des disques de freins d'avions.

### Arrière-plan de l'invention

La demande EP 2 253 604 propose un procédé pour obtenir une pièce de friction en matériau composite carbone/carbone (C/C) incorporant une phase céramique. Cette pièce de friction présente une faible usure et un coefficient de friction adapté à l'application au freinage et stable, notamment lors de freinage à haute énergie.

Le procédé divulgué dans cette demande comprend la réalisation d'une préforme en fils de carbone, la densification de la préforme par une matrice de carbone et, au cours du processus de fabrication, l'introduction de grains ou particules en céramique dispersés au sein de la pièce. Plus précisément, la demande EP 2 253 604 divulgue de réaliser, préalablement à l'achèvement de la densification, une imprégnation par un liquide formé par une solution de type sol-gel et/ou une suspension colloïdale permettant la dispersion d'un ou plusieurs composé(s) du zirconium. Il est alors obtenu, dans la pièce finale, des grains ou cristallites dont la composition est au moins majoritairement de type ZrOₓC_{y} avec 1 ≤ x ≤ 2 et 0 ≤ y ≤ 1.

La pièce de friction obtenue par le procédé décrit dans la demande EP 2 253 604 présente de bonnes performances. En revanche, ce procédé est plus complexe que le procédé standard de réalisation d'un disque entièrement C/C. En effet dans cette demande, l'insertion du ou des composés à base de zirconium, est réalisée lors d'une étape par voie liquide, totalement dissociée de celle consistant à élaborer le pyrocarbone par densification par voie gazeuse (CVI).

En particulier, il est divulgué dans la demande EP 2 253 604 de réaliser l'insertion du zirconium, après un premier stade de densification par du pyrocarbone par CVI. La pièce est alors déchargée du four CVI puis immergée dans un sol précurseur de zircone, séchée et traitée thermiquement. La pièce est alors à nouveau introduite dans le four CVI, pour terminer la densification de la matrice pyrocarbone. Cette insertion du zirconium, totalement dissociée du procédé d'infiltration chimique en phase vapeur, occasionne une complexification et un rallongement de la fabrication.

Il serait souhaitable de simplifier le procédé de fabrication de pièces de friction en matériau composite C/C incorporant une phase céramique de zirconium.

### Objet et résumé de l'invention

L'invention vise un procédé de fabrication d'une pièce de friction en matériau composite, comprenant au moins l'étape suivante :
- densification d'une préforme fibreuse en fils de carbone par une matrice comprenant au moins du pyrocarbone (PyC) et au moins une phase ZrOₓC_{y}, où 1 ≤ x ≤ 2 et 0 ≤ y ≤ 1, la matrice étant formée par infiltration chimique en phase vapeur (CVI) au moins à partir d'un premier précurseur gazeux de pyrocarbone et d'un deuxième précurseur gazeux comprenant du zirconium, ledit deuxième précurseur étant un alcool ou un polyalcool en C₁ à C₆ modifié par liaison de l'atome d'oxygène d'au moins une fonction alcool à un groupement de formule -Zr-R₃, les substituants R étant identiques ou différents, et R étant choisi parmi : -H, les chaînes carbonées en C₁ à C₅ et les atomes d'halogène.

Par « alcool », il faut comprendre un composé ayant une seule fonction alcool. Par « polyalcool », il faut comprendre un composé ayant plusieurs fonctions alcool.

Le deuxième précurseur utilisé ici est un alcool ou un polyalcool en C₁ à C₆ fonctionnalisé, au niveau de l'atome d'oxygène d'au moins une fonction alcool, par un groupement formé par du zirconium Zr auquel sont liés trois substituants R. Le précurseur présente la formule générale suivante : CH - O - Zr - R₃, où CH désigne la chaîne carbonée en C₁ à C₆ de l'alcool ou du polyalcool, et O l'atome d'oxygène de la fonction alcool lié au zirconium.

Le deuxième précurseur alcool ou polyalcool modifié permet avantageusement d'obtenir la phase ZrOₓC_{y} par mise en œuvre d'un procédé d'infiltration chimique en phase vapeur. Par rapport aux précurseurs à base de zirconium commerciaux, le deuxième précurseur présente notamment l'avantage d'avoir une température de décomposition compatible avec les températures classiquement utilisées en CVI pour former du PyC, simplifiant ainsi la mise en œuvre de la densification. Le deuxième précurseur présente en outre un coût réduit et une bonne stabilité chimique, par rapport aux précurseurs à base de zirconium commerciaux. Dans un cas particulier, y peut être égal à 0 dans la formule plus haut si l'on ajoute un oxydant dans la phase gazeuse afin d'oxyder le carbone du deuxième précurseur. Un tel oxydant peut être le dioxygène O₂ ou un NOₓ. Une autre possibilité pour réduire l'apport de carbone est d'abaisser la température de traitement CVI afin que le carbone ne se craque pas et reste en phase gazeuse.

L'invention permet d'obtenir une pièce de friction ayant les performances souhaitées en termes tribologiques et de résistance à l'usure, de manière plus simple que dans l'art antérieur. En particulier, il est possible de s'affranchir des étapes de déchargement du four et de rechargement dans le four effectuées dans l'état de la technique en formant la matrice uniquement par CVI.

En outre, l'alcool ou le polyalcool sur lequel le zirconium est greffé constitue un composé disponible en grande quantité et qui peut être obtenu à partir de ressources renouvelables, conférant ainsi au deuxième précurseur décrit plus haut une disponibilité accrue par rapport aux précurseurs à base de zirconium commerciaux.

Dans un exemple de réalisation, la densification comprend :
- un premier cycle de densification dans lequel une première phase de matrice de pyrocarbone est formée à partir du premier précurseur,
- un deuxième cycle de densification, réalisé après le premier cycle, dans lequel une deuxième phase de matrice comprenant la phase ZrOₓC_{y} est formée au moins à partir du deuxième précurseur, et
- un troisième cycle de densification, réalisé après le deuxième cycle, dans lequel une troisième phase de matrice de pyrocarbone est formée à partir d'un troisième précurseur gazeux de pyrocarbone, identique ou différent du premier précurseur.

Dans un exemple de réalisation, la densification comprend au moins la formation d'un co-dépôt du pyrocarbone et de la phase ZrOₓC_{y} à partir d'un mélange gazeux d'un précurseur gazeux de pyrocarbone et du deuxième précurseur.

Dans un exemple de réalisation, R est choisi parmi : -H, les chaînes carbonées en C₁ à C₃ et les atomes d'halogène.

Dans un exemple de réalisation, au moins un substituant R est une chaîne carbonée en C₁ à C₅, voire en C₁ à C₃, ou un atome d'halogène. En d'autres termes dans ce cas, les substituants R rattachés au zirconium ne sont pas tous -H.

Dans un exemple de réalisation, le procédé comprend, en outre, un traitement thermique de désoxygénation de la phase ZrOₓC_{y} formée.

Dans un exemple de réalisation, la phase ZrOₓC_{y}, éventuellement désoxygénée, est présente, dans la pièce finale, en une teneur massique comprise entre 0,5% et 25%, par exemple comprise entre 2% et 10%.

Dans un exemple de réalisation, la pièce de friction est un disque de frein.

### Brève description des dessins

D'autres caractéristiques et avantages de l'invention ressortiront de la description suivante, donnée à titre non limitatif, en référence aux dessins annexés, sur lesquels :
- la figure 1 est un ordinogramme montrant différentes étapes d'un premier exemple de procédé selon l'invention, et
- la figure 2 est un ordinogramme montrant différentes étapes d'un deuxième exemple de procédé selon l'invention.

### Description détaillée de modes de réalisation

Dans la description qui suit, il est plus particulièrement envisagé la réalisation de disques à base de matériau composite C/C pour des freins d'avion. Toutefois, l'invention est applicable à la réalisation d'autres pièces de friction à base de matériau composite C/C, telles que des disques de frein pour des véhicules terrestres, notamment des automobiles, et des pièces de friction autres que des disques, notamment des patins.

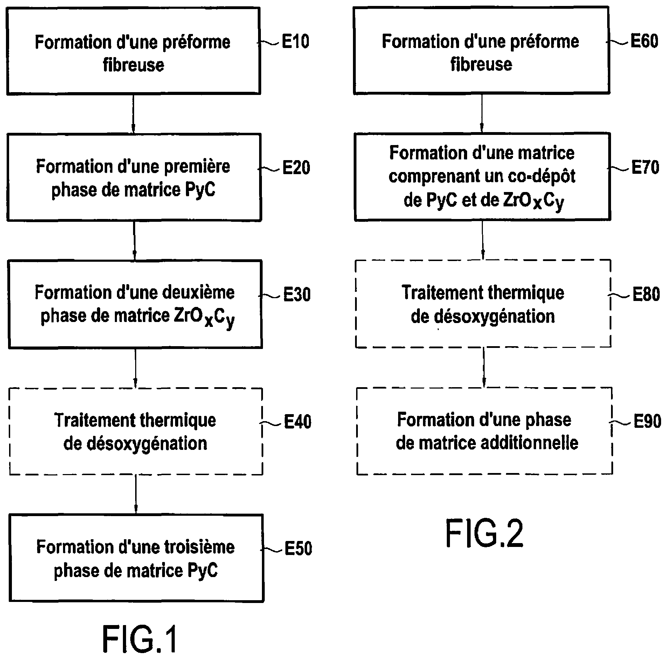

Un premier exemple de mise en œuvre d'un procédé selon l'invention est illustré par la figure 1.

Une première étape consiste à réaliser une préforme en fils de carbone pour disque de frein (étape E10). Une telle préforme est par exemple réalisée par superposition de strates découpées dans une texture fibreuse en fils de précurseur de carbone, liaison des strates entre elles par aiguilletage et transformation du précurseur en carbone par traitement thermique.

En variante, on peut aussi réaliser une préforme annulaire par enroulement en spires superposées d'un tissu hélicoïdal en fils de précurseur de carbone, liaison des spires entre elles par aiguilletage et transformation du précurseur par traitement thermique. On pourra par exemple se référer aux documents US 5 792 715, US 6 009 605 et US 6 363 593.

On peut aussi réaliser la préforme directement à partir de strates de texture fibreuse en fils de carbone qui sont superposées et liées entre elles par exemple par aiguilletage.

On réalise ensuite une densification par CVI afin de densifier la préforme par la matrice.

Pour cela, la préforme fibreuse à densifier est placée dans une enceinte réactionnelle de CVI. On peut mettre en œuvre une enceinte réactionnelle adaptée à la formation de PyC, connue en soi.

Dans l'exemple associé à l'ordinogramme de la figure 1, la densification comprend un premier cycle de densification dans lequel une première phase de matrice PyC est formée à partir du premier précurseur (étape E20). La première phase PyC peut être formée directement sur les fils formant la préforme.

On obtient, après le premier cycle de densification et avant le début du deuxième cycle de densification, une préforme partiellement densifiée par la première phase de matrice PyC. La première phase de matrice PyC peut occuper entre 5% et 60%, par exemple entre 10% et 30%, de la porosité initiale de la préforme fibreuse.

On réalise ensuite un deuxième cycle de densification durant lequel une deuxième phase de matrice comprenant la phase ZrOₓC_{y} est formée au moins à partir du deuxième précurseur (étape E30). La deuxième phase de matrice peut être formée directement sur la première phase de matrice PyC. Selon cet exemple, l'introduction du deuxième précurseur gazeux dans l'enceinte réactionnelle est initiée lors du passage du premier au deuxième cycle de densification.

Selon un exemple, le deuxième précurseur peut constituer l'unique gaz réactif introduit dans l'enceinte réactionnelle durant le deuxième cycle de densification (pas de précurseur de PyC introduit dans ce cas). Auquel cas, on forme uniquement durant ce deuxième cycle la phase ZrOₓC_{y}.

En variante, on peut introduire, dans l'enceinte réactionnelle, un mélange d'un précurseur de PyC et du deuxième précurseur durant le deuxième cycle de densification. Auquel cas, on obtient un co-dépôt de la phase ZrOₓC_{y} et de PyC. Dans ce dernier cas, le précurseur de PyC peut être le premier ou le troisième précurseur ou un précurseur de PyC différent du premier et du troisième précurseur. La deuxième phase de matrice peut occuper entre 1% et 10%, par exemple entre 2% et 7%, de la porosité initiale de la préforme.

Si cela est souhaité, un traitement thermique (étape E40 optionnelle) de désoxygénation peut être réalisé afin d'éliminer une partie au moins des liaisons existantes entre le zirconium et l'oxygène dans la phase ZrOₓC_{y} obtenue. Ce traitement permet de moduler la stoechiométrie de cette phase. On peut en particulier, après désoxygénation, transformer la phase ZrOₓC_{y} en phase de ZrC. Selon l'exemple illustré, le traitement thermique de désoxygénation est réalisé après le deuxième cycle de densification et avant le début du troisième cycle de densification.

Le traitement thermique de désoxygénation constitue un traitement connu en soi. Il va des connaissances générales de l'homme du métier de déterminer la durée et la température à mettre en œuvre durant ce traitement de désoxygénation, en fonction du matériau souhaité à obtenir.

La température imposée durant le traitement de désoxygénation peut être supérieure à la température maximale rencontrée durant la formation de la matrice.

On réalise ensuite un troisième cycle de densification durant lequel une troisième phase de matrice PyC est formée à partir d'un troisième précurseur gazeux de PyC, identique ou différent du premier précurseur (étape E50). La troisième phase de matrice peut être formée directement sur la deuxième phase de matrice, éventuellement désoxygénée. Selon cet exemple, l'introduction du deuxième précurseur dans l'enceinte réactionnelle est stoppée à la fin du deuxième cycle de densification et n'est pas reprise durant le troisième cycle de densification.

Le premier et le troisième précurseurs peuvent, indépendamment l'un de l'autre, être choisis parmi : le gaz naturel, le méthane, le propane, l'éthanol ou un mélange de ces composés.

Le deuxième précurseur peut être obtenu par modification de l'alcool ou du polyalcool en C₁ à C₆ en mettant en œuvre des réactions de chimie organique connues de l'homme du métier, afin de lier de manière covalente l'atome d'oxygène de la fonction alcool au groupement -Zr-R₃. Cette liaison peut être réalisée par substitution nucléophile de l'atome d'oxygène de la fonction alcool sur le zirconium.

A titre d'exemple de deuxième précurseur utilisable, on peut utiliser un alcool ou un polyalcool en C₁-C₆ modifié par greffage du réactif de Schwartz (C₅H₅)₂ZrHCl sur l'oxygène de l'alcool. Ce greffage est réalisé par réaction de substitution nucléophile par liaison de l'oxygène de la fonction alcool au zirconium et départ du chlore du réactif de Schwartz.

R est pour chaque occurrence, de manière identique ou différente, -H, une chaîne carbonée en C₁ à C₅, comme un radical alkyle en C₁ à C₅, ou un atome d'halogène.

Plus particulièrement, R peut être pour chaque occurrence, de manière identique ou différente, -H, une chaîne carbonée en C₁ à C₃, comme un radical alkyle en C₁ à C₃, ou un atome d'halogène.

Plus particulièrement encore, R peut être pour chaque occurrence, de manière identique ou différente, -H, un radical méthyle ou un atome d'halogène.

Dans un exemple de réalisation, l'alcool ou le polyalcool est en C₂ à C₄. L'alcool ou le polyalcool peut présenter une chaîne linéaire, ramifiée ou cyclique.

Dans un exemple de réalisation, l'alcool ou le polyalcool (avant modification par liaison au zirconium) est choisi parmi : le méthanol, l'éthanol, l'éthylène glycol, le propanol, le glycérol, le butanol, le pentanol, l'hexanol, le cyclopropanol, le cyclobutanol, le cyclopentanol, le cyclohexanol ou un phénol. En particulier, l'alcool est l'éthanol.

Selon un exemple, le précurseur est un polyalcool modifié et les atomes d'oxygène de chaque fonction alcool peuvent être liés à un groupement -Zr-R₃, où R est tel que décrit plus haut, les groupements - Zr-R₃ étant dans ce cas identiques ou différents. En variante, seule une partie des fonctions alcool peuvent être fonctionnalisées par un groupement -Zr-R₃.

L'invention peut être mise en œuvre dans une installation de CVI connue adaptée à la densification PyC comprenant une ligne d'introduction supplémentaire permettant d'injecter le deuxième précurseur gazeux dans l'enceinte réactionnelle. Le deuxième précurseur peut être introduit dans l'enceinte réactionnelle par des moyens connus en soi communément utilisés dans la CVI pour introduire le précurseur à l'état gazeux.

On peut réaliser la densification dans une enceinte réactionnelle à une température d'environ 1000°C et sous une pression de préférence inférieure à 5 kPa. Ces conditions correspondent aux conditions de température et de pression typiquement utilisées pour former du PyC par CVI.

Dans l'exemple qui vient d'être décrit en lien avec la figure 1, on forme séquentiellement la première phase de matrice PyC, puis la deuxième phase de matrice comprenant la phase ZrOₓC_{y}, puis la troisième phase de matrice PyC. On obtient ainsi une matrice séquencée comprenant au moins une première et troisième couches de PyC et une deuxième couche comprenant la phase ZrOₓC_{y} intercalée entre les première et troisième couches. Dans une variante de procédé non illustrée, on peut s'affranchir de la formation de cette troisième phase de matrice. Auquel cas, on forme d'abord une première phase de matrice PyC comme décrit plus haut, puis une deuxième phase de matrice ZrOₓC_{y} comme décrit plus haut. La densification de la préforme peut ainsi être terminée par la formation de cette deuxième phase de matrice.

On va maintenant décrire une variante de procédé selon l'invention en lien avec la figure 2.

Dans l'exemple de la figure 2, le procédé comprend d'abord la formation d'une préforme fibreuse (étape E60) puis la densification de cette préforme, laquelle comprend au moins la formation d'un co-dépôt de PyC et de la phase ZrOₓC_{y} (étape E70).

On peut, en particulier, obtenir des inclusions de ZrOₓC_{y} réparties dans tout le volume de la matrice. Ces inclusions ZrOₓC_{y} sont dispersées dans la matrice de pyrocarbone.

La matrice formée à partir des premier et deuxième précurseurs peut occuper au moins 50%, voire au moins 75%, de la porosité initiale de la préforme fibreuse. L'intégralité de la matrice peut être formée par un co-dépôt de PyC et de la phase ZrOₓC_{y}. Ainsi, la préforme peut intégralement densifiée par ce co-dépôt. En variante, seule une partie de la matrice peut être formée par un co-dépôt de PyC et de la phase ZrOₓC_{y}, le reste de la matrice ayant une composition différente.

Le co-dépôt de PyC et de la phase ZrOₓC_{y} peut avoir une composition uniforme (le co-dépôt présente une composition homogène). Dans ce cas, les proportions relatives entre le gaz précurseur de PyC et le deuxième précurseur à base de zirconium sont maintenues constantes lors du co-dépôt.

En variante, la composition du co-dépôt de PyC et de la phase ZrOₓC_{y} peut varier. Dans ce cas, les proportions relatives entre le gaz précurseur de PyC et le deuxième précurseur à base de zirconium sont modifiées lors du co-dépôt. Cette modification des proportions relatives lors du dépôt permet de contrôler localement la proportion de la phase de ZrOₓC_{y} formée dans la matrice obtenue.

De manière similaire à ce qui a été décrit plus haut, un traitement thermique de désoxygénation (étape E80) peut être réalisé une fois le co-dépôt réalisé, si cela est souhaité. Après ce traitement thermique de désoxygénation E80, une densification par une phase de matrice additionnelle E90 peut être réalisée, de manière optionnelle. La phase de matrice additionnelle peut par exemple être du PyC.

Les détails décrits plus haut relatifs à la préforme fibreuse, aux précurseurs de PyC et de ZrOₓC_{y} et aux conditions opératoires CVI restent applicables à l'exemple de la figure 2.

Les proportions relatives entre le ou les précurseurs PyC et le deuxième précurseur de ZrOₓC_{y} injectés déterminent la teneur massique de la phase ZrOₓC_{y} obtenue dans la pièce finale. On peut en particulier obtenir dans la pièce finale une teneur comprise entre 0,5% et 25%, voire entre 2% et 10%, pour la phase ZrOₓC_{y}, cette phase pouvant ou non avoir subi le traitement de désoxygénation évoqué plus haut.

L'expression « compris(e) entre ... et ... » doit se comprendre comme incluant les bornes.

## Revendications

1. Procédé de fabrication d'une pièce de friction en matériau composite, comprenant au moins l'étape suivante :
- densification d'une préforme fibreuse en fils de carbone par une matrice comprenant au moins du pyrocarbone et au moins une phase ZrOₓC_{y}, où 1 ≤ x ≤ 2 et 0 ≤ y ≤ 1, la matrice étant formée par infiltration chimique en phase vapeur au moins à partir d'un premier précurseur gazeux de pyrocarbone et d'un deuxième précurseur gazeux comprenant du zirconium, ledit deuxième précurseur étant un alcool ou un polyalcool en C₁ à C₆ modifié par liaison de l'atome d'oxygène d'au moins une fonction alcool à un groupement de formule -Zr-R₃, les substituants R étant identiques ou différents, et R étant choisi parmi : -H, les chaînes carbonées en C₁ à C₅ et les atomes d'halogène.

2. Procédé selon la revendication 1, dans lequel la densification comprend :
- un premier cycle de densification dans lequel une première phase de matrice de pyrocarbone est formée à partir du premier précurseur,
- un deuxième cycle de densification, réalisé après le premier cycle, dans lequel une deuxième phase de matrice comprenant la phase ZrOₓC_{y} est formée au moins à partir du deuxième précurseur, et
- un troisième cycle de densification, réalisé après le deuxième cycle, dans lequel une troisième phase de matrice de pyrocarbone est formée à partir d'un troisième précurseur gazeux de pyrocarbone, identique ou différent du premier précurseur.

3. Procédé selon la revendication 1 ou 2, dans lequel la densification comprend au moins la formation d'un co-dépôt de la phase de pyrocarbone et de la phase ZrOₓC_{y} à partir d'un mélange gazeux d'un précurseur gazeux de pyrocarbone et du deuxième précurseur.

4. Procédé selon l'une quelconque des revendications 1 à 3, dans lequel R est choisi parmi : -H, les chaînes carbonées en C₁ à C₃ et les atomes d'halogène.

5. Procédé selon l'une quelconque des revendications 1 à 4, dans lequel au moins un substituant R est une chaîne carbonée en C₁ à C₅, voire en C₁ à C₃, ou un atome d'halogène.

6. Procédé selon l'une quelconque des revendications 1 à 5, dans lequel le procédé comprend, en outre, un traitement thermique de désoxygénation de la phase ZrOₓC_{y} formée.

7. Procédé selon l'une quelconque des revendications 1 à 6, dans lequel la phase ZrOₓC_{y}, éventuellement désoxygénée, est présente, dans la pièce finale, en une teneur massique comprise entre 0,5% et 25%.

8. Procédé selon la revendication 7, dans lequel la phase ZrOₓC_{y}, éventuellement désoxygénée, est présente, dans la pièce finale, en une teneur massique comprise entre 2% et 10%.

9. Procédé selon l'une quelconque des revendications 1 à 8, dans lequel la pièce de friction est un disque de frein.

## Patentansprüche

1. Verfahren zur Herstellung eines Reibteils aus Verbundwerkstoff, das mindestens den folgenden Schritt umfasst:
- Verdichten einer faserigen Vorform aus Kohlenstofffäden durch eine Matrix, die mindestens Pyrokohlenstoff und mindestens eine ZrOₓC_{y}-Phase umfasst, wobei 1 ≤ x ≤ 2 und 0 ≤ y ≤ 1, wobei die Matrix durch chemische Gasphaseninfiltration mindestens ausgehend von einem ersten gasförmigen Pyrokohlenstoff-Vorläufer und einem zweiten gasförmigen Vorläufer gebildet wird, der Zirkonium umfasst, wobei der zweite Vorläufer ein C₁- bis C₆-Alkohol oder -Polyalkohol ist, der durch Bindung des Sauerstoffatoms von mindestens einer Alkoholfunktion an eine Gruppe mit der Formel -Zr-R₃ modifiziert wird, wobei die Substituenten R identisch oder unterschiedlich sind und R ausgewählt wird aus: -H, C₁- bis C₅- Kohlenstoffketten und Halogenatomen.

2. Verfahren nach Anspruch 1, wobei die Verdichtung umfasst:
- einen ersten Verdichtungszyklus, in dem eine erste Pyrokohlenstoffmatrixphase ausgehend von dem ersten Vorläufer gebildet wird,
- einen zweiten Verdichtungszyklus, der nach dem ersten Zyklus ausgeführt wird und in dem eine zweite Matrixphase, welche die ZrOₓC_{y}-Phase umfasst, mindestens ausgehend von dem zweiten Vorläufer gebildet wird, und
- einen dritten Verdichtungszyklus, der nach dem zweiten Zyklus ausgeführt wird und in dem eine dritte Pyrokohlenstoffmatrixphase ausgehend von einem dritten gasförmigen Pyrokohlenstoff-Vorläufer gebildet wird, der mit dem ersten Vorläufer identisch ist oder sich davon unterscheidet.

3. Verfahren nach Anspruch 1 oder 2, wobei das Verdichten mindestens das Bilden einer kombinierten Abscheidung der Pyrokohlenstoffphase und der ZrOₓC_{y}-Phase ausgehend von einem gasförmigen Gemisch eines gasförmigen Pyrokohlenstoff-Vorläufers und des zweiten Vorläufers umfasst.

4. Verfahren nach einem der Ansprüche 1 bis 3, wobei R ausgewählt wird aus: -H, C₁- bis C₃-Kohlenstoffketten und Halogenatomen.

5. Verfahren nach einem der Ansprüche 1 bis 4, wobei mindestens ein Substituent R eine C₁- bis C₅- oder C₁- bis C₃- Kohlenstoffkette oder ein Halogenatom ist.

6. Verfahren nach einem der Ansprüche 1 bis 5, wobei das Verfahren ferner eine Wärmebehandlung zum Sauerstoffentzug von der gebildeten ZrOₓC_{y}-Phase umfasst.

7. Verfahren nach einem der Ansprüche 1 bis 6, wobei die ZrOₓC_{y}-Phase, der gegebenenfalls Sauerstoff entzogen wurde, in dem Endteil mit einem Massenanteil von zwischen 0,5 % und 25 % vorhanden ist.

8. Verfahren nach Anspruch 7, wobei die ZrOₓC_{y}-Phase, der gegebenenfalls Sauerstoff entzogen wurde, in dem Endteil mit einem Massenanteil von zwischen 2 % und 10 % vorhanden ist.

9. Verfahren nach einem der Ansprüche 1 bis 8, wobei das Reibteil eine Bremsscheibe ist.

## Claims

1. A process for manufacturing a friction component of composite material, comprising at least the following step:
- densification of a fibrous preform of carbon yarns by a matrix comprising at least pyrocarbon and at least one ZrOₓC_{y} phase, where 1 ≤ x ≤ 2 and 0 ≤ y ≤ 1, the matrix being formed by chemical vapor infiltration at least from a first gaseous precursor of pyrocarbon and a second gaseous precursor comprising zirconium, said second precursor being an alcohol or a C₁ to C₆ polyalcohol modified by linking the oxygen atom of at least one alcohol function to a group of formula -Zr-R₃, the substituents R being identical or different, and R being selected from: -H, C₁ to C₅ carbon chains and halogen atoms.

2. The process claimed in claim 1, wherein the densification comprises:
- a first densification cycle in which a first pyrocarbon matrix phase is formed from the first precursor,
- a second densification cycle, carried out after the first cycle, in which a second matrix phase comprising the ZrOₓC_{y} phase is formed at least from the second precursor, and
- a third densification cycle, carried out after the second cycle, in which a third pyrocarbon matrix phase is formed from a third gaseous pyrocarbon precursor, identical or different from the first precursor.

3. The process claimed in claim 1 or 2, wherein densification comprises at least the formation of a co-deposition of the pyrocarbon phase and the ZrOₓC_{y} phase from a gaseous mixture of a gaseous pyrocarbon precursor and the second precursor.

4. The process as claimed in any one of claims 1 to 3, wherein R is selected from: -H, C₁ to C₃ carbon chains and halogen atoms.

5. The process as claimed in any one of claims 1 to 4, wherein at least one substituent R is a C₁ to C₅ or C₁ to C₃ carbon chain or a halogen atom.

6. The process as claimed in any one of claims 1 to 5, wherein the process further comprises a deoxygenation heat treatment of the ZrOₓC_{y} phase formed.

7. The process as claimed in any one of claims 1 to 6, in which the ZrOₓC_{y} phase, optionally deoxygenated, is present, in the final component, in a mass content of between 0.5% and 25%.

8. The process claimed in claim 7, in which the ZrOₓC_{y} phase, optionally deoxygenated, is present, in the final component, in a mass content of between 2% and 10%.

9. The process as claimed in any one of claims 1 to 8, wherein the friction component is a brake disc.
